Europäisches Patentamt

European Patent Office

Office européen des brevets

(11) Publication number: **0 035 326**
A2

# EUROPEAN PATENT APPLICATION

(21) Application number: 81300487.6

(22) Date of filing: 05.02.81

(51) Int. Cl.³: **G 11 C 8/00**, G 11 C 11/40, H 03 K 13/25

(30) Priority: 08.02.80 JP 14576/80

(43) Date of publication of application: 09.09.81 Bulletin 81/36

(84) Designated Contracting States: **AT BE CH DE FR GB IT LI LU NL SE**

(71) Applicant: **FUJITSU LIMITED, 1015, Kamikodanaka Nakahara-ku, Kawasaki-shi Kanagawa 211 (JP)**

(72) Inventor: **Isogai, Hideaki, 11-13, Minamisawa 4-chome Higashikurume-shi, Tokyo 180-03 (JP)**

(74) Representative: **Sunderland, James Harry et al, HASELTINE LAKE & CO Hazlitt House 28 Southampton Buildings Chancery Lane, London WC2A 1AT (GB)**

(54) **Decoder circuit.**

(57) The decoder circuit receives address signals $A_0$ to $A_3$ and selects one of $4 \times 4$ (=16) word lines $W_1$ to $W_{16}$ for driving a semiconductor memory device for example. The decoder circuit has a high level selection circuit HS which receives upper address signals $A_0$ and $A_1$ and produces four outputs $E_1$ to $E_4$, one of which is of a high level, while others are of a low level; and a low level selection circuit LS which receives lower address signals $A_2$ and $A_3$ and produces four outputs $F_1$ to $F_4$, one of which is of low level, while the others are of high level; and $4 \times 4$ (=16) coupling circuits $CP_1$ to $CP_{16}$ each of which corresponds to one of the word lines and each of which receives one output from the high level selection circuit HS and one output from the low level selection circuit LS. Each coupling circuit $CP_1$ to $CP_{16}$ selects a corresponding word line $W_1$ to $W_{16}$ only when the outputs of the high level selection circuit and the low level selection circuit which it is connected to receive are respectively and simultaneously high level and low level.

0035326

-1-

DECODER CIRCUIT

The present invention relates to a decoder circuit for example for a semiconductor memory device.

Previously proposed decoder circuits are of three main types, i.e., a type of decoder circuit having a high level selection circuit (hereinafter referred to as an H decoder), a type of decoder circuit having a low level selection circuit (hereinafter referred to as an L decoder), and a type of decoder circuit having two stages of high level selection circuits (hereinafter referred to as a two-stage H decoder). The H decoder can offer the advantage of simplified gatecircuits, but consumes a relatively large amount of electric power in comparison with other types of decoder because when one of the outputs of the decoder is to be selected the other outputs must be grounded by conducting currents through elements connected between those other outputs and ground. The L decoder can offer an advantage of relatively low power consumption in comparison with the other types of decoders because when one of the outputs of the decoder is to be selected only that one output must be grounded. However, the L decoder has a disadvantage in that the number of input gates is limited because of its circuit structure.

As a two-stage H decoder, Japanese Patent Application No. 50-84820 (Japanese Patent Laid-Open No. 52-8739) discloses, as hereinafter described in detail, a system which utilises an emitter coupled logic (ECL) and a diode (or a multi-emitter) matrix, and which selects or does not

0035326

select the diode matrix in a two-dimensional manner or in a higher dimensional manner, in order to reduce the consumption of electric power and to reduce the number of elements in the decoder circuit.

The decoder circuit mentioned above is advantageous with regard to reduced power consumption and reduced number of elements as compared with a conventional decoder circuit, but has a defect in that the output waveform is subject to distortion because of low driving capacity of the high level selection circuit. Therefore, when a reading level is higher than a point at which the output waveform rises slowly, access time tends to be delayed. Further, in the above-mentioned decoder circuit although power consumption is reduced by employing ECL and a diode (or a multi-emitter) matrix, it would be advantageous to reduce further the power consumption in a decoder circuit.

According to the present invention there is provided a decoder circuit, for receiving a plurality of address signals and for selecting one of $n$ x $m$ lines in dependence upon the values of the address signals, including a high level selection circuit, for receiving some of the address signals of the plurality, having $n$ outputs and operable to set one of the $n$ outputs at high level, for specifying one of $n$ line groups (which one depending upon the values of the address signals received by the high level selection circuit), and to provide (n-1) low level outputs in respect of the others of the $n$ line groups, a low level selection circuit, for receiving the rest of the address signals of the plurality, having $m$ outputs and operable to set one of the $m$ outputs at low level, for specifying one of $m$ line groups (which one depending upon the values of the address signals received by the low level selection circuit), and to provide (m-1) high level outputs in respect of the others of the $m$ line groups, and $n$ x $m$ coupling circuits, corresponding respectively to the $n$ x $m$ lines, each connected to one output of the high level selection circuit and one output of the low level selection circuit and adapted to select the

0035326

corresponding line when the high level selection circuit output and the low level selection circuit output connected thereto are respectively and simultaneously high level and low level.

An embodiment of the present invention can provide a decoder circuit which consumes relatively little electric power as compared with previously proposed decoders as mentioned above.

An embodiment of the present invention can provide a decoder circuit having output waveforms which rise and fall rapidly without any substantial distortion.

An embodiment of the present invention can provide a decoder circuit which can operate at high speed.

Briefly, a decoder circuit embodying this invention which receives a plurality of address signals, and which selects one of n x m word lines for driving a semiconductor memory device, comprises; a high level selection circuit which receives a part of the plurality of address signals, and which produces one high level output for specifying one of n word line groups, and which produces (n-1) low level outputs for the rest of the n word line groups; a low level selection circuit which receives the rest of the plurality of address signals, and which produces one low level output for specifying one of m word line groups, and which produces (m-1) high level outputs for the rest of the m word line groups, and; n x m coupling circuits each of which receives one output from the high level selection circuit and one output from the low level selection circuit and which corresponds to one of the n x m word lines, each of the coupling circuits being adapted to select the corresponding word line when the high level output from the high level selection circuit and the low level output from the low level selection circuit are simultaneously applied to the coupling circuit.

It is preferable that each of the coupling circuits comprises a pnp transistor having an emitter connected to one of the outputs of the high level selection circuit, having a base connected to one of the outputs of the low level selection circuit, and having a collector connected to one of n x m word drivers.

Reference is made, by way of example, to the accompanying drawings, in which:-

Figure 1 is a schematic block diagram of a memory device;

Figure 2 is a circuit diagram of a previously proposed two-stage H decoder constructed to deal with addresses consisting of four bits, used in the memory device of Figure 1;

Figure 3 is a schematic diagram illustrating an output waveform of the circuit of Figure 2;

Figure 4 is a circuit diagram of a decoder circuit according to one embodiment of the present invention;

Figure 5 is a circuit diagram illustrating a main portion of a decoder circuit according to another embodiment of the present invention; and

Figure 6 is a schematic diagram illustrating an output waveform of a decoder circuit according to an embodiment of the present invention.

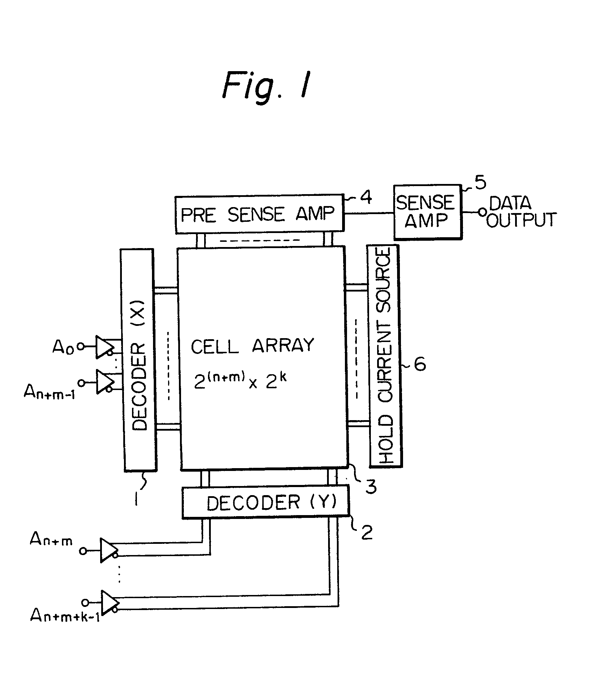

Figure 1 illustrates the structure of an integrated circuit memory device. Referring to Figure 1, a decoder (X) 1 and a decoder (Y) 2 are connected to a cell array 3. The decoder (X) 1 and the decoder (Y) 2 receive address signals $A_0 \ldots A_{n+m-1}$ and $A_{n+m} \ldots A_{n+m+k-1}$, respectively, and the cells arranged in matrix form are selected by the outputs of the decoder (X) 1 and the decoder (Y) 2. A presense amplifier 4 writes or reads information from or into a cell selected by the outputs of the decoder (X) 1 and the decoder (Y) 2. Read data is amplified by a sense amplifier 5. A hold current source 6 is provided for holding information in memory cells of the cell array 3.

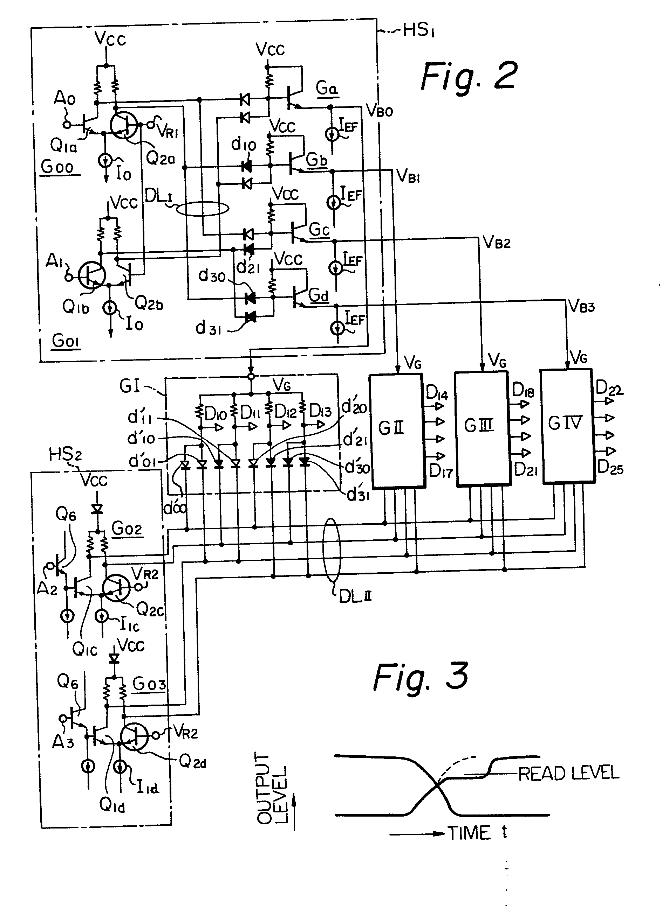

An embodiment of the present invention will be explained with reference to problems arising in connection with the decoder circuit (X) 1 in Figure 1. However, before explaining an embodiment of the present invention, a previously proposed two-stage H decoder will first be explained with reference to Figures 2 and 3.

Figure 2 is a circuit diagram of a previously proposed two-stage H decoder as constructed to deal with addresses consisting of four bits, and, for example, as used in the memory device of Figure 1.

Referring to Figure 2, four first stage gate circuits $G_{00}$, $G_{01}$, $G_{02}$ and $G_{03}$ are divided into two groups, i.e., a first high level selection circuit $HS_1$ comprising the gate circuits $G_{00}$ and $G_{01}$, and a second high level selection circuit $HS_2$ comprising the gate circuits $G_{02}$ and $G_{03}$.

Gate circuit $G_{00}$ comprises transistors $Q_{1a}$ and $Q_{2a}$ and a constant current source $I_0$. Gate circuit $G_{01}$ comprises transistors $Q_{1b}$ and $Q_{2b}$ and a constant current source $I_0$. A voltage $V_{R1}$ is supplied to the bases of transistors $Q_{2a}$ and $Q_{2b}$.

Gate circuit $G_{02}$ comprises a transistor $Q_6$, transistors $Q_{1c}$ and $Q_{2c}$, and a constant current source $I_{1c}$. Gate circuit $G_{03}$ comprises a transistor $Q_6$, transistors $Q_{1d}$ and $Q_{2d}$, and a constant current source $I_{1d}$. A voltage $V_{R2}$ is supplied to the bases of transistors $Q_{2c}$ and $Q_{2d}$.

$V_{CC}$ is a supply voltage.

Outputs of gate circuits $G_{00}$ and $G_{01}$ are provided on lines $DL_I$ and outputs of gate circuits $G_{02}$ and $G_{03}$ are provided on lines $DL_{II}$.

The first high level selection circuit $HS_1$ also comprises decoder parts Ga, Gb, Gc and Gd, each having a transistor, a resistor, a constant current source $I_{EF}$ and two diodes. The diodes of each decoder part are selectively connected to lines $DL_I$. Only diodes $d_{10}$, $d_{21}$, $d_{30}$ and $d_{31}$ are labelled.

$V_{BO}$, $V_{B1}$, $V_{B2}$ and $V_{B3}$ are outputs of $HS_1$ provided by the decoder parts.

Second stage gate circuits are divided into four groups, GI, GII, GIII, and GIV. Each of the four groups GI, GII, GIII, and GIV provides four outputs $D_{10}$ to $D_{13}$, $D_{14}$ to $D_{17}$, $D_{18}$ to $D_{21}$, and $D_{22}$ to $D_{25}$, respectively. Therefore, a total of sixteen outputs $D_{10}$ to $D_{25}$ are provided in this decoder circuit.

The groups GI to GIV respectively receive the outputs $V_{B0}$ to $V_{B3}$ of $HS_1$ at respective electric source terminals $V_G$ thereof.

GI comprises diodes d'00, d'01, d'10, d'11, d'20, d'21, d'30, d'31, selectively connected to lines $DL_{II}$.

Input binary signals consisting of four bits are divided into upper digits 0 and 1 (bits $A_0$ and $A_1$), and lower digits 2 and 3 (bits $A_2$ and $A_3$). The former digits are fed to the upper (as seen in Figure 2) first stage gate circuits $G_{00}$ and $G_{01}$ so that one of outputs $V_{B0}$, $V_{B1}$, $V_{B2}$ and $V_{B3}$ of the first high level selection circuit $HS_1$ will become of high potential depending on the values of bits $A_0$ and $A_1$, while the other outputs will become of ground potential. The latter digits are fed to the lower (as seen in Figure 2) first stage gate circuits $G_{02}$ and $G_{03}$ outputs of which are fed in parallel as decoding input signals to each of the second stage gate circuits GI, GII, GIII and GIV, whereby any one of the sixteen outputs of the gate circuits GI, GII, GIII and GIV is allowed to produce a high potential level.

When the input signals $A_0$, $A_1$, $A_2$ and $A_3$ are assumed to have L, H, L and L levels, respectively, where L denotes a low potential level and H denotes a high potential level, that is, when these input signals have logical values 0, 1, 0, and 0, respectively, the upper bits 01 are supplied to the first stage gate circuits $G_{00}$ and $G_{01}$ in the first high level selection circuit $HS_1$, so that the transistors $Q_{2a}$ and $Q_{1b}$ are placed in an on state (indicated by rings around those transistors in Figure 2). Accordingly, in decoder parts Ga, Gb, Gc and Gd, diodes $d_{10}$, $d_{21}$, $d_{30}$ and $d_{31}$ are placed in an on state, so that the decoder part Ga alone generates an output having a high level. The outputs $V_{B0}$, $V_{B1}$, $V_{B2}$ and $V_{B3}$ of the decoder parts are supplied to electric source terminals $V_G$ of the decoder second stage circuits GI to GIV, and only circuit GI is placed in an operative condition and the other circuits GII to GIV are placed in a non operative condition. Thus, the decoder second stage circuit GI is selected by the upper two bits of the input signal.

The lower two bits 00 of the input signal are supplied to the gate circuits $G_{02}$ and $G_{03}$ in the second high level selection circuit $HS_2$ so that transistors $Q_{2c}$ and $Q_{2d}$ are placed in the on state. Accordingly, diodes d'10, d'21, d'30 and d'31 in the gate circuit GI are placed in the on state, so that only the output $D_{10}$ is placed at high level.

When the input signals $A_0$ to $A_3$ have a different combination of H and L values, in a manner similar to the above-mentioned operations one of the outputs $D_{10}$ to $D_{25}$ of the second stage gate circuits GI to GIV is placed in a high level state, so that 16 pieces of information included in a four bit binary signal can be decoded.

Since both of the two groups of the first stage are high level selection circuits as mentioned above, the two-stage H decoder as illustrated in Figure 2 consumes a relatively large amount of electric power. For example, with respect to the second high level selection circuit $HS_2$ and the gate circuit GI, if the output $D_{10}$ is to be selected, the circuit $HS_2$ must conduct currents through diodes d'10, d'21, d'30 and d'31 which are connected to the other (non-selected) outputs $D_{11}$, $D_{12}$ and $D_{13}$, respectively, and only the diodes d'00 and d'01, which are connected to the output $D_{10}$, do not conduct any current therethrough so that the output $D_{10}$ is kept at a high potential level. Therefore, for the selection of one output, currents must be conducted through elements connected to the other three outputs. This results in a high power consumption.

Furthermore, the two-stage H decoder of Figure 2 presents another defect in that an output waveform thereof suffers distortion as illustrated in Figure 3. When the output waveform rises from low level to high level, it should ideally rise substantially as indicated by the broken line in Figure 3. In practice, however, the output waveform is as indicated by a solid line in Figure 3. Therefore, when a reading level is higher than a certain value, access time tends to be extended e.g. delayed. The distortion in the output waveform is caused by the fact that the first high level selection circuit $HS_1$ must drive one of the four groups GI, GII, GIII and GIV and the high level selection circuit $HS_2$, so that the load capacitance on the first high level selection circuit $HS_1$ is too large to permit smooth driving.

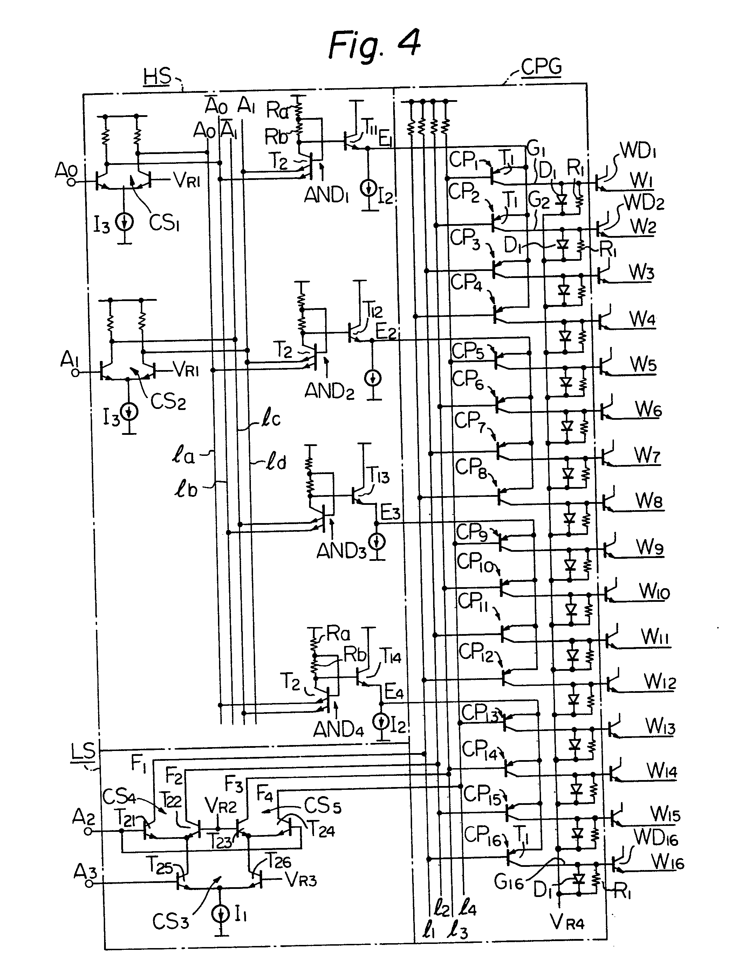

Embodiments of the present invention will now be explained by way of example. Figure 4 illustrates a decoder circuit embodying the present invention. The decoder circuit is arranged to receive, as an example, four-bit address signals $A_0$, $A_1$, $A_2$ and $A_3$, for addressing word lines, and selects any one of sixteen word lines $W_1$ to $W_{16}$ in dependence upon the address signals. Referring to Figure 4, HS denotes a high level selection circuit (hereinafter referred to as an H selection circuit) for receiving the upper two bits of address signals $(A_0$ and $A_1)$ and selecting one of four outputs $E_1$, $E_2$, $E_3$ and $E_4$ of HS to be a high potential level (selected level), while the other three outputs are brought down to a low potential level (non-selected level). LS denotes a low level selection circuit (hereinafter referred to as an L selection circuit) for receiving the lower two bits of address signals $(A_2$ and $A_3)$ and selecting one of four outputs $F_1$, $F_2$, $F_3$ and $F_4$ of LS to be of a low potential level (selected level), while the other three outputs remain at a high potential level (non-selected level). CPG represents a group of sixteen coupling circuits $CP_1$ to $CP_{16}$, for receiving the outputs $E_1$ to $E_4$ of the H selection circuit HS and the outputs $F_1$ to $F_4$ of the L selection circuit LS. Each coupling circuit $CP_1$, $CP_2$, ..., or $CP_{16}$ is operated only when it receives an H level output from the H selection circuit HS and an L level output from the L selection circuit LS. When one of the coupling circuits is operated, that one of the word lines $W_1$ to $W_{16}$ connected to the coupling circuit is selected. $WD_1$ to $WD_{16}$ represent word drivers corresponding to the word lines $W_1$ to $W_{16}$ respectively. The potential of the base $G_1$, $G_2$, ..., $G_{16}$ of each word driver is controlled by the output of the corresponding coupling circuit $CP_1$, $CP_2$, ... , $CP_{16}$. Each of the coupling circuits $CP_1$ to $CP_{16}$ is comprised of a pnp transistor $T_1$ the collector of which is connected to the base of the corresponding word driver, and a bias circuit comprised of a resistance $R_1$ and a diode $D_1$ connected in parallel, the anode of the diode $D_1$ being connected to the base of the corresponding word driver and the cathode of the diode $D_1$ being connected to a reference voltage source $V_{R4}$. In respective coupling circuits the base and the emitter of each transistor $T_1$ are connected to different points. That is, the emitter of each transistor $T_1$ in the coupling circuits $CP_1$ to $CP_4$ is connected to the emitter of an npn transistor $T_{11}$ which provides the output $E_1$ of the H selection circuit HS. Similarly, the emitter of each transistor $T_1$ in the coupling circuits $CP_5$ to $CP_8$ is connected to the emitter of a transistor $T_{12}$; the emitter of each transistor $T_1$ in the coupling circuits $CP_9$ to $CP_{12}$ is connected to the emitter of a transistor $T_{13}$; and the emitter of each transistor $T_1$ in the coupling circuits $CP_{13}$ to $CP_{16}$ is connected to the emitter of a transistor $T_{14}$. The bases of the transistors $T_1$, in each group of the coupling circuits $CP_1$ to $CP_4$, $CP_5$ to $CP_8$, $CP_9$ to $CP_{12}$ and $CP_{13}$ to $CP_{16}$ are connected to bus lines $l_1$, $l_2$, $l_3$ and $l_4$, respectively, which receive the outputs $F_1$, $F_2$, $F_3$ and $F_4$ of the L selection circuit LS, respectively. That is, the bases of the transistors $T_1$ in the coupling circuits $CP_4$, $CP_8$, $CP_{12}$ and $CP_{16}$ are connected to the bus line $l_1$ which is connected to the collector of an npn transistor $T_{21}$ in the L selection circuit LS. Similarly, the bases of transistors $T_1$ in the coupling circuits $CP_3$, $CP_7$, $CP_{11}$, and $CP_{15}$ are connected through the bus line $l_2$ to the

collector of a transistor $T_{22}$ in the L selection circuit LS; the bases of the transistors $T_1$ in the coupling circuits $CP_2$, $CP_6$, $CP_{10}$ and $CP_{14}$ are connected through the bus line $l_3$ to the collector of a transistor $T_{23}$, and the bases of the transistors $T_1$ in the coupling circuits $CP_1$, $CP_5$, $CP_9$ and $CP_{13}$ are connected through the bus line $l_4$ to the collector of a transistor $T_{24}$.

The operation of the decoder circuit of Figure 4 will now be explained. When the transistor $T_1$ in a coupling circuit $CP_i$ (where i = 1, 2, ..., 16) is in the OFF state, the reference voltage $V_{R4}$ is applied through a resistor $R_1$ to the base of the word driver $WD_i$. Since the reference voltage $V_{R4}$ is set at a low level, the output of the word driver $WD_i$, that is, the word line $W_i$ is the L level (non-selected level). In contrast to this, when the transistor $T_1$ is turned ON, a current will flow from a power supply through the H selection circuit HS, the transistor $T_1$ and the diode $D_1$ to the reference voltage source $V_{R4}$, so that the base potential of the word driver $WD_i$ will increase by the amount of the forward voltage of the diode $D_1$, resulting in the potential of the word line $W_i$ being increased to the selected high level. The potential of the base of the word driver $WD_i$ is in general, in practice, between -1.2 and -1.6 volts for the high level and between -2.0 and -2.4 volts for the low level. The reference voltage $V_{R4}$ is the same as the potential of the base of the word driver $WD_i$ for the low level. The transistor $T_1$ is turned on only when its emitter potential is at high level and its base potential is at low level. This condition can be realised in only one coupling circuit from amongst the sixteen coupling circuits $CP_1$ to $CP_{16}$, as can be seen from the illustrated circuit diagram when considering the possible output situations of the H selection circuit HS and the L selection circuit LS.

The H selection circuit HS is comprised of a first current switch $CS_1$, or, in other words, a first address inverter $CS_1$, which provides the address signal $A_0$ and its inverted signal $\overline{A_0}$ by comparing the address signal

$A_0$ with a reference voltage $V_{R1}$; a second current switch $CS_2$, that is, a second address inverter $CS_2$, which provides the address signal $A_1$ and its inverted signal $\overline{A_1}$; and four AND gates $AND_1$, $AND_2$, $AND_3$ and $AND_4$, each of which is comprised of a multi-emitter transistor $T_2$ arranged for receiving a predetermined pair of inputs from amongst the four address signals $A_0$, $\overline{A_0}$, $A_1$ and $\overline{A_1}$ which are provided to bus lines $l_a$, $l_b$, $l_c$, and $l_d$. The outputs of the AND gates $AND_1$ to $AND_4$ control the base potentials of transistors $T_{11}$, $T_{12}$, $T_{13}$ and $T_{14}$ which provide the four outputs $E_1$, $E_2$, $E_3$ and $E_4$ of the H selection circuit HS, respectively. $I_2$ and $I_3$ represent constant current sources. $R_a$ and $R_b$ represent resistances. When both inputs to an AND gate $AND_n$, where n is 1, 2, 3 or 4, are high level H, the AND gate $AND_n$ provides a high level output, which is supplied to the base of the transistor $T_{1n}$ to turn it on so that its output $E_n$ becomes high level. Only one of the four AND gates receives the high level signal at its two inputs. Therefore, only one of the four outputs $E_1$, $E_2$, $E_3$ and $E_4$ becomes of high level, while the other three outputs remain at low level.

The L selection circuit LS is a circuit of a series gate type and is comprises of a third current switch $CS_3$ including transistors $T_{25}$ and $T_{26}$ for comparing the input signal $A_3$ with a reference voltage $V_{R3}$; a fourth current switch $CS_4$, which is operative when the transistor $T_{25}$ is in the ON state, for comparing the input signal $A_2$ with a reference voltage $V_{R2}$; a fifth current switch $CS_5$, which is operative when the transistor $T_{26}$ is in the ON state, for comparing the input signal $A_2$ with the reference voltage $V_{R2}$; and a constant current source $I_1$ connected to the emitters of the transistors $T_{25}$ and $T_{26}$. When the address signals $A_2$ and $A_3$ are supplied to the L selection circuit, only one transistor $T_{2m}$ of the four transistors $T_{21}$, $T_{22}$, $T_{23}$ and $T_{24}$, and only one transistor of the two transistors $T_{25}$ and $T_{26}$ will be turned on so that current will flow through the transistor $T_{2m}$ to the

current source $I_1$, causing the output $F_m$ of the transistor $T_{2m}$ to take a low level L, while the other three outputs remain at a high level H.

When the address signals $A_0$ and $A_1$ are supplied to the H selection circuit HS, only one selected AND gate $AND_n$ and the transistor $T_{1n}$ connected to the AND gate $AND_n$ are not turned ON, and the other three non-selected AND gates and the transistors connected to them are turned ON so that currents flow therethrough. In contrast to this, when the address signals $A_2$ and $A_3$ are supplied to the L selection circuit LS, only one transistor $T_{2m}$ (m = 1, 2, 3 or 4) and the transistor $T_{25}$ or $T_{26}$ connected to the transistor $T_{2m}$ are turned on to conduct a current therethrough, and the other transistors are not turned on. Therefore, the L selection circuit LS consumes a relatively small amount of electric power in comparison with the H selection circuit. In the conventional two-stage H decoder, the H selection circuit HS was used in place of the L selection circuit LS. Therefore, the power consumption in the decoder circuit embodying the present invention and described above is reduced to about half of the power consumption in the conventional two-stage H decoder.

Furthermore, a decoder circuit embodying the present invention has another advantage in that it has output waveforms which rise and fall rapidly without any substantial distortion. This advantage is also due to the employment of the H selection circuit HS and the L selection circuit LS. That is, in the decoder circuit embodying the present invention as described above, the H selection circuit HS may only drive a part of the coupling circuit roup CPG. Therefore, the load capacitance of the H selection circuit HS is sufficiently low for the driving capacity of the circuit HS. Since the output waveform has no substantial distortion, the output waveform can rise or fall rapidly, and, the rise or fall time can be shortened by about 5 ns in comparison with a conventional two-stage H decoder, when these decoders are applied to a 4K memory cell array.

In an embodiment of the present invention, the rise or fall time of the output waveform can also be shortened because the amplitude of the output signal at each output of the H selection circuit HS or the L selection circuit LS may be only half of the amplitude required in a conventional decoder circuit. That is, in general, a decoder circuit has a large parasitic capacitance which causes a large time constant. In order to obtain a predetermined amplitude, for example, 0.8 volts, of a word line for accurately driving memory cells, a large amplitude was required for the output signal from a conventional decoder circuit. Therefore, due to the large time constant, the access time to the memory cells tends to be delayed in the conventional decoder circuit. In contrast to this, however, in an embodiment of the present invention, since the emitter and base potentials of each transistor $T_1$ in the coupling circuit group CPG are supplied from the H selection circuit HS and the L selection circuit LS, respectively, the required amplitude of each output $E_1$, $E_2$, $E_3$, $E_4$, $F_1$, $F_2$, $F_3$ and $F_4$ need only be half of the potential difference required between the emitter and the base of the transistor $T_1$ for turning $T_1$ completely ON. For example, when a potential difference of 0.8 volts is required to turn the transistor $T_1$ ON, the amplitude of each output of the H selection circuit HS and of the L selection circuit LS may be 0.4 volts, and therefore, a rapid rise or fall of the output waveform can be obtained.

The small amplitude required in a decoder circuit embodying the present invention also provides for low power consumption.

As a practical example, let it be assumed that the transistor $T_1$ in the coupling circuit $CP_1$ is to be turned ON. In this case, the high level at the output of the AND gate $AND_1$ is 0 volts. Therefore, the high level at the output $E_1$ is -0.8 volts. The potential at the output $E_1$ is applied as the high level to the emitter of the transistor $T_1$ in the coupling circuit $CP_1$. On the other

hand, in an off state of the AND gate $AND_1$, the low level at the output $E_1$ must be lower than the high level by 0.4 volts, and therefore the low level is -1.2 volts. Thus, the low level at the output of the AND gate $AND_1$ is -0.4 volts. Accordingly, the amplitude of the potential at the collector of the AND gate $AND_1$ is equal to 0.4 volts, while in the conventional decoder circuit, the amplitude is required to be 0.8 volts.

The amplitude of the potentials between the high level and the low level at the collector of each AND gate $AND_n$ determines the amplitudes of bus lines $1_a$, $1_b$, $1_c$ and $1_d$. Therefore, the amplitudes of the bus lines $1_a$, $1_b$, $1_c$ and $1_d$ can also be reduced in an embodiment of the present invention. In addition, the amplitude of each bus line $1_a$, $1_b$, $1_c$ and $1_d$ can be made smaller than the amplitude of each output $E_1$, $E_2$, $E_3$ and $E_4$, which is equal to 0.4 volts as mentioned above. That is, resistances $R_a$ and $R_b$ connected to the collector of the transistor $T_2$ in each AND gate function as a potential divider, so that the required amplitude of each bus line $1_a$, $1_b$, $1_c$ and $1_d$ is $E.R_a/(R_a+R_b)$, where E is the amplitude of the output $E_n$ of the H selection circuit HS. In conventional decoder circuits, such potential dividers have also been used to reduce the amplitudes of bus lines. However, since the amplitude of the collector of each transistor in such a conventional decoder circuit was twice that provided by the embodiment of the present invention, the potential at the base of each transistor could not be much smaller. If the potential at the base of each transistor is reduced to any considerable extent, in a conventional decoder circuit, by increasing the dividing ratio of the potential divider, the transistor will be saturated so that the operating speed of the transistor will be reduced. Therefore, the dividing ratio could not be much increased in such a conventional decoder circuit and thus the amplitudes of bus lines could not be reduced to the extent permitted by the embodiment of the present invention. In contrast, in an embodiment of the present invention, the amplitudes of the bus lines $1_a$, $1_b$, $1_c$ and

$l_d$ can be greatly reduced without causing problems of saturation of the transistor $T_2$.

With respect to the amplitude of the base potential of each transistor $T_1$ in the coupling circuit group CPG, a similar explanation to that given above with respect to the amplitude of the emitter potential of each transistor $T_1$ can be applied. Thus, the amplitude of the potential of the base of each transistor $T_1$ can also be reduced in accordance with an embodiment of the present invention. The base of each transistor $T_1$ is connected to a bus line $l_1$, $l_2$, $l_3$ or $l_4$. Therefore, the amplitude of each bus line $l_1$, $l_2$, $l_3$ and $l_4$ can also be reduced. Although the bus lines $l_1$ to $l_4$ have large load capacitances, the operating speed of the decoder embodying the present invention can be increased because of the reduced amplitudes of the bus lines.

Practical values of the high level and the low level of the base potential of the transistor $T_1$ are -1.6 volts and -2.0 volts, respectively. The L selection circuit LS provides the high level potential and the low level potential. The high level and the low level of the base potential $G_i$ of each word driver $WD_i$ are -1.2 volts and -2.0 volts, respectively. The reference voltage $V_{R4}$ is -2.0 volts.

Other advantages can also be obtained by using a decoder circuit embodying the present invention. Firstly, since a pnp transistor $T_1$ can be used in each coupling circuit, the word driver $WD_i$ has no load resistance at its base, when the decoder circuit is seen from the side of the word line $W_i$. Because of this, rapid access to memory cells can be effected. The resistance $R_1$ connected between the base of each word driver $WD_i$ and the reference voltage $V_{R4}$ does not function as a load when the word line $W_i$ is driven, because the resistance $R_1$ only functions to provide the low level potential to the base of the word driver $WD_i$. Secondly, since the L selection circuit LS is the series gate type, only one constant current source $I_1$ is required. Therefore,

the number of elements required for a decoder circuit embodying the present invention is reduced so that power consumption is reduced. Thirdly, since the non-selected level of each word line $W_i$ is determined by the single reference voltage $V_{R4}$, the non-selected level is constant for all of the word lines $W_1$ to $W_{16}$. This constant non-selected level also results in high speed of access to memory cells, and also results in an increase in the reliability of the operation of the memory cells.

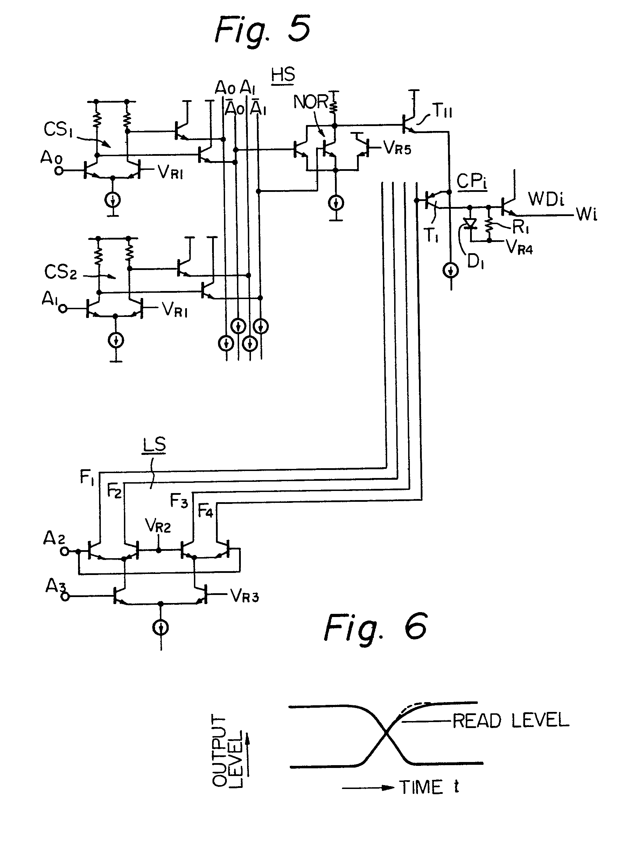

Figure 5 is a circuit diagram illustrating a main portion of a decoder according to another embodiment of the present invention. Referring to Figure 5, the logical construction of an H selection circuit HS' differs from that of the H selection circuit HS in the decoder circuit of Figure 4. In Figure 5, NOR denotes one of four NOR gates for receiving two of the four address signals $A_0$, $\overline{A_0}$, $A_1$ and $\overline{A_1}$. In this embodiment the NOR gate receives the address signals $\overline{A_0}$ and $\overline{A_1}$. When both of the two inputs are of low level, the NOR gate provides an output of high level. In the other cases, the NOR gate provides an output of low level. These NOR gates correspond to the AND gates in the circuit of Figure 4. That is, a NOR gate and a AND gate provide a high level output, respectively, only when their two inputs are both of low level and both of high level, respectively.

Other previously proposed high level selection circuits may also be used in a decoder circuit embodying the present invention, with the same effects obtained as by the decoder circuit of Figure 4.

Figure 6 is a diagram illustrating the output waveform of a decoder circuit embodying the present invention. By comparing the diagram of Figure 6 with that of Figure 3 relating to a conventional decoder circuit, it is apparent that, for an embodiment of the present invention, the output waveform has substantially no distortion and rises or falls rapidly.

From the foregoing description, it will be apparent that, in a decoder circuit embodying the present invention, operating speed can be greatly increased and power consumption greatly reduced.

It should be noted that although the illustrated embodiments are described in relation to cases in which the bit number of address signals is four bits, embodiments of the present invention can deal with any bit number by increasing or decreasing the number of elements in the decoder circuit. Also, with respect to the input signals, the number of upper bits need not always be equal to the number of lower bits.

Thus, an embodiment of the present invention provides a decoder circuit which receives a plurality of address signals and selects one of n x m word lines for driving a semiconductor memory device, comprising: a high level selection circuit which receives the upper address signals and produces n outputs, one of the n outputs is selected to be at high level, while the other (n-1) outputs are made to take a low level; a low level selection circuit which receives the lower address signals and produces m outputs, one of the m outputs is selected to be of low level, while the other (m-1) outputs are made to take a high level; and n x m coupling circuits each of each receives one output from the high level selection circuit and one output from the low level selection circuit and which corresponds to one of the n x m word lines. Each of the coupling circuits selects the corresponding word line when a high level output from the high level selection circuit and a low level output from the low level selection circuit are simultaneously applied to the coupling circuit.

CLAIMS

1.    A decoder circuit, for receiving a plurality of
address signals and for selecting one of $n$ x $m$ lines in
dependence upon the values of the address signals,
including a high level selection circuit, for receiving
some of the address signals of the plurality, having $n$
outputs and operable to set one of the $n$ outputs
at high level, for specifying one of $n$ line groups
(which one depending upon the values of the address
signals received by the high level selection circuit),
and to provide ($n$-1) low level outputs in respect of
the others of the $n$ line groups, a low level selection
circuit, for receiving the rest of the address signals
of the plurality, having $m$ outputs and operable to
set one of the $m$ outputs at low level, for specifying
one of $m$ line groups (which one depending upon the
values of the address signals received by the low level
selection circuit), and to provide ($m$-1) high level
outputs in respect of the others of the $m$ line groups,
and $n$ x $m$ coupling circuits, corresponding respectively
to the $n$ x $m$ lines, each connected to one output of the
high level selection circuit and one output of the low
level selection circuit and adapted to select the
corresponding line when the high level selection circuit
output and the low level selection circuit output
connected thereto are respectively and simultaneously
high level and low level.

2.    A decoder circuit as claimed in claim 1, wherein
each of the coupling circuits comprises a pnp transistor
having an emitter connected to one of the outputs of
the high level selection circuit, having a base connected
to one of outputs of the low level selection circuit,
and having a collector connected to one of $n$ x $m$ line drivers
provided for driving respective lines.

3.    A decoder circuit as claimed in claim 2, wherein
the collectors of all the pnp transistors are
connected through resistors, respectively, to a single
reference voltage source.

4.    A decoder circuit as claimed in any preceding claim, wherein the low level selection circuit comprises
a plurality of current switches connected in a series
gate type arrangement for providing the one low level
output and the (m-1) high level outputs.

5.    A decoder circuit as claimed in claim 4, wherein
each of the current switches comprises a pair of
npn transistors, the emitters of the transistors of
each pair being connected to one another, the base
of one transistor of each pair being arranged for receiving
one of the address signals, the base of the other
transistor of the pair being arranged for receiving
a reference voltage, and wherein the outputs of the
low level selection circuit are supplied from collectors
of npn transistors.

6.    A decoder circuit as claimed in claim 4 or 5,
wherein the low level selection circuit further comprises
a single constant current source for driving the plurality
of current switches.

7.    A decoder circuit as claimed in any preceding
claim, wherein the high level selection circuit comprises
a plurality of AND gates, each having two inputs for
receiving signals derived from address signals received
by the high level selection circuit, and having an
output from which a high level is delivered only when the
signals received at the two inputs are high level.

8.    A decoder circuit as claimed in any one of claims
1 to 6, wherein the high level selection circuit
comprises a plurality of NOR gates, each having two inputs
for receiving signals derived from address signals
received by the high level selection circuit, and having
an output from which a high level is delivered only
when the signals received at the two inputs are low
level.

9.    A decoder circuit as claimed in any preceding claim,
wherein the $n$ x $m$ lines are word lines of_ ... .. ...
a semiconductor memory device.

10.    A semiconductor memory device including a decoder
circuit as claimed in claim 9.

## Fig. 1

PRE SENSE AMP ~4 | SENSE AMP ~5 | DATA OUTPUT

DECODER (X)

$A_0$

$A_{n+m-1}$

CELL ARRAY $2^{(n+m)} \times 2^k$

HOLD CURRENT SOURCE ~6

~1

~3

DECODER (Y)

~2

$A_{n+m}$

$A_{n+m+k-1}$

2/4

*Fig. 2*

*Fig. 3*

Fig. 4

0035326

3/4

Fig. 5

Fig. 6